# EUROPEAN PATENT APPLICATION

(11) **EP 4 539 115 A2**
(43) Date of publication of application: **16.04.2025**
(21) Application number: 24205854.3
(22) Date of filing: 10.10.2024
(51) Int. Cl.: H01L 23/16, H01L 23/00, H01L 25/03

(54) **SYSTEM AND METHODS FOR AN EMBEDDED BRIDGE ARCHITECTURE**

(30) Priority: 10.10.2023 US 202363543504 P; 10.10.2023 US 202363543505 P; 03.09.2024 US 202418823660
(71) Applicant: Samsung Electronics Co., Ltd, Suwon-si, Gyeonggi-do 16677 (KR)
(72) Inventor: YANG, Jin, San Jose, CA 95134 (US); SCOTT, Martin, San Jose, CA 95134 (US); SUBRAMANIAN, Ramkumar, San Jose, CA 95134 (US); BALASUBRAMANIAN, Sriram, San Jose, CA 95134 (US); KIM, Woopoung, San Jose, CA 95134 (US)
(74) Representative: Kuhnen & Wacker Patent- und Rechtsanwaltsbüro PartG mbB

(57) **Abstract**

Disclosed herein are methods, systems and devices including a first layer, the first layer including a first compute device (108), a first multi-device package (113), and a second multi-device package (114). The first compute device (108) may be between the first multi-device package (113) and the second multi-device package (114). A second layer may include a first redistribution layer (105) on a first side of the second layer facing the first layer, the first redistribution layer (105) electrically connecting the first compute device (108) to the first multi-device package (113) and the first redistribution layer (105) electrically connecting the first compute device (108) to the second multi-device package (114). The first layer may include a third multi-device package (115) and a fourth multi-device package (116), with the first compute device (108) between the third multi-device package (113) and the fourth multi-device package (114).

## Description

### TECHNICAL FIELD

The subject matter disclosed herein relates to microelectronics packaging and integrated circuits (IC) packaging. More particularly, the subject matter disclosed herein relates to a package architecture featuring bridges.

### BACKGROUND

Semiconductor devices may connect to additional devices and circuitry on different substrates. Forming connections between substrates can provide increased computation. However, forming connections between substrates can cause complications. Packaging describes the general method for connecting and integrating multiple computational components together in an integrated unit, and may involve multiple different types of integrated circuits on multiple substrates which may combine into a single unit. Packaging may also describe the method for which multiple computational components within a single unit are protected by the use of various techniques to provide thermal, physical and electrical protection. Background concepts discussed herein are for informational purposes only and are not intended to limit the present disclosure. Nor should the background or field described herein be intended to limit the disclosure herein to a particular use or concept.

### SUMMARY

An example embodiment provides a device including a first layer, the first layer including a first compute device, a first multi-device package, and a second multi-device package. The first compute device may be between the first multi-device package and the second multi-device package. A second layer may include a first redistribution layer on a first side of the second layer facing the first layer, the first redistribution layer electrically connecting the first compute device to the first multi-device package and the first redistribution layer electrically connecting the first compute device to the second multi-device package. The first layer may include a third multi-device package and a fourth multi-device package, with the first compute device between the third multi-device package and the fourth multi-device package. The first redistribution layer may electrically connect the first compute device to the third multi-device package and the first redistribution layer may electrically connect the first compute device to the fourth multi-device package. The first compute device may be between the second multi-device package and fourth multi-device package. The first layer may include a second compute device, a fifth multi-device package, and a sixth multi-device package, with the second compute device between the sixth multi-device package and the fifth multi-device package. The first redistribution layer may electrically connect the second compute device and the sixth multi-device package and the first redistribution layer may electrically connect the second compute device and the fifth multi-device package. The second layer may include a second redistribution layer on a second side of the second layer, the second side opposite the first side. A first bridge may be arranged between the first redistribution layer and the second redistribution layer. The first multi-device package may include at least a first device stack and a second device stack on a first multi-device die. The first device stack may include one or more of a memory device and a processing device. The first multi-device die may electrically connect the first device stack and the second device stack to the first redistribution layer.

An example embodiment provides a system, the system including a first layer with a first compute device, a first multi-device package, and a second multi-device package. The first compute device may between the first multi-device package and the second multi-device package. A second layer may include a first bridge and a second bridge, the first bridge electrically coupling the first compute device to the first multi-device package and the second bridge electrically coupling the first compute device to the second multi-device package. The first layer may include a second compute device, a third multi-device package and a fourth multi-device package. The second layer may include a third bridge and a fourth bridge, with the third bridge electrically connecting the second compute device to the third multi-device package and the fourth bridge electrically connecting the second compute device to the fourth multi-device package. The second layer may include a first redistribution layer on a first side of the second layer, the first redistribution layer between the first bridge and the first multi-device package. The second layer may include a second redistribution layer, the second redistribution layer on a second side of the second layer, opposite the first side, the first bridge between the first redistribution layer and the second redistribution layer. The first multi-device package may include at least one memory device or processing device. The first layer may include a base die, the base die between the first compute device and the first bridge.

An example embodiment provides a method including forming an interposer with a first bridge and a second bridge; forming a first redistribution layer on a first side of the interposer, the first redistribution layer communicatively coupled to the first bridge and the second bridge; mounting a compute device on the interposer and on the first redistribution layer; mounting a first multi-device package and a second multi-device package on the interposer and on the first redistribution layer, the compute device arranged between the first multi-device package and the second multi-device package; depositing a dielectric layer over the interposer, coupling the first multi-device package to the compute device via the first bridge; and coupling the second multi-device package to the compute device via the second bridge. The first multi-device package and the second multi-device package may have substantially the same devices. Mounting the compute device on the interposer may include mounting a base die on the first redistribution layer and mounting the compute device on the base die. Forming the interposer may include forming a second redistribution layer on a second side of the interposer, the second side opposite the first side. Depositing the dielectric layer over the interposer may include deposition dielectric material between the first multi-device package, the second multi-device package, and the compute device.

### BRIEF DESCRIPTION OF THE DRAWING

In the following section, the aspects of the subject matter disclosed herein will be described with reference to exemplary embodiments illustrated in the figures, in which:
FIG. 1A depicts a perspective view of an example embodiment of a packaging structure according to various embodiments of the subject matter disclosed herein;
FIG. 1B depicts an enlarged perspective view of an example embodiment of a packaging structure according to various embodiments of the subject matter disclosed herein;
FIG. 2 depicts a plan view of an example embodiment of a packaging structure according to various embodiments of the subject matter disclosed herein;
FIG. 3 depicts a cross-sectional view of an example embodiment of a packaging structure according to various embodiments of the subject matter disclosed herein;
FIG. 4A depicts a cross-sectional view of an example embodiment of a packaging structure assembly at a first time according to various embodiments of the subject matter disclosed herein;
FIG. 4B depicts a cross-sectional view of an example embodiment of a packaging structure assembly at a second time according to various embodiments of the subject matter disclosed herein;
FIG. 4C depicts a cross-sectional view of an example embodiment of a packaging structure assembly at a third time according to various embodiments of the subject matter disclosed herein;
FIG. 4D depicts a cross-sectional view of an example embodiment of a packaging structure assembly at a fourth time according to various embodiments of the subject matter disclosed herein;
FIG. 5 depicts an example embodiment of a method of forming a package structure according to various embodiments of the subject matter disclosed herein;
FIG. 6 depicts a cross-sectional view of an example embodiment of a packaging structure assembly according to various embodiments of the subject matter disclosed herein;
FIG. 7 depicts a plan view of an example embodiment of a packaging structure assembly according to various embodiments of the subject matter disclosed herein;
FIG. 8A depicts a cross-sectional view of an example embodiment of a packaging structure assembly at a first time according to various embodiments of the subject matter disclosed herein;
FIG. 8B depicts a cross-sectional view of an example embodiment of a packaging structure assembly at a second time according to various embodiments of the subject matter disclosed herein;
FIG. 8C depicts a cross-sectional view of an example embodiment of a packaging structure assembly at a third time according to various embodiments of the subject matter disclosed herein;
FIG.8D depicts a cross-sectional view of an example embodiment of a packaging structure assembly at a fourth time according to various embodiments of the subject matter disclosed herein;
FIG.8E depicts a cross-sectional view of an example embodiment of a packaging structure assembly at a fifth time according to various embodiments of the subject matter disclosed herein;
FIG.8F depicts a cross-sectional view of an example embodiment of a packaging structure assembly at a sixth time according to various embodiments of the subject matter disclosed herein;
FIG.8G depicts a cross-sectional view of an example embodiment of a packaging structure assembly at a seventh time according to various embodiments of the subject matter disclosed herein; and
FIG. 9 depicts an example embodiment of a method of forming a package structure according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Three-Dimensional," etc.) may be interchangeably used with a corresponding non-capitalized version (e.g., "counter clockwise," "three-dimensional," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, the substrates may contain circuits such as integrated circuits including central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), graphical processing units (GPUs), other forms of auxiliary processing units (xPU), Artificial intelligence (AI) chips, High bandwidth memory (HBM) interfaces, and other application-specific integrated circuits (ASIC). In some embodiments, a combination of circuits may be present on a substrate. In some embodiments, a substrate may include a packaged chip.

As used herein, high bandwidth memory or HBM, may refer to a chip structure including one or more HBM modules. In some embodiments, the HBM may be manufactured by an advance silicon node process.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be connected using a via traveling through an interposer such as another substrate or chip. In some embodiments, an interconnection may be formed using connections on a surface of a substrate, such as a pad, and may use additional materials between the pads such as solder to form an interconnection.

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and Ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, hybrid bonding may be defined as bonding both conductive portions to conductive portions such as a metal-metal bond, and bonding dielectric portions to dielectric portions such as a dielectric-dielectric bond.

As used herein, a bridge refers to a substrate, die, or other material having one or more conductive pathways able to form connection between one or more semiconductor devices, as well as substrates, interposers, or other package structures. A bridge may include one or more traces, the traces forming a connection pathway along the bridge between one or more devices coupled to the bridge. An embedded bridge, as used herein, may refer to a bridge in a layer within a semiconductor package, and may be used interchangeably with bridge.

Disclosed herein are various embodiments of devices, systems and methods related to packaging architecture to modularly create a stack logic and memory building block architecture. Increasing the number of devices and number of device stacks may utilize additional methods of connecting compute devices to device stacks to allow denser computation. A stack logic and memory building block architecture may include a base chip providing logic, routing, and power delivery to one or more device stacks. A multiple-stack die may include one or more device stacks on a shared substrate. The multiple-stack die may then be mounted on a shared interposer with a compute device and additional multiple-stack dies. Signals between the compute devices and the device stacks may be routed via the shared interposer, including via one or more bridges which may be embedded in the shared interposer between two or more redistribution layers. As used herein, a device stack or stack of devices may refer to a combination of memory and supporting circuit architecture, for example, chiplets and dies containing individual memory elements, supporting processing units, I/O circuitry, and other forms of integrated chips.

In some embodiments, a back-side power delivery network (BSPDN) may be formed on the backside of a substrate, with a signal network formed on the front side of the same substrate. In some embodiments, the BSPDN and signal network may be formed on separate substrates and transferred to the same substrate. The BSPDN and signal network may be separated by a transistor layer. The transistor layer may include a plurality of transistors. The transistors may provide different functions and take different forms, including a logic layer. The B SPDN and signal network may form a single monolithic structure on the same die in a semiconductor foundry process. A stacked device module may separately be formed in a semiconductor foundry process, the same semiconductor foundry process, or may have multiple components formed in multiple semiconductor foundry processes and assembled in a packaging assembly process.

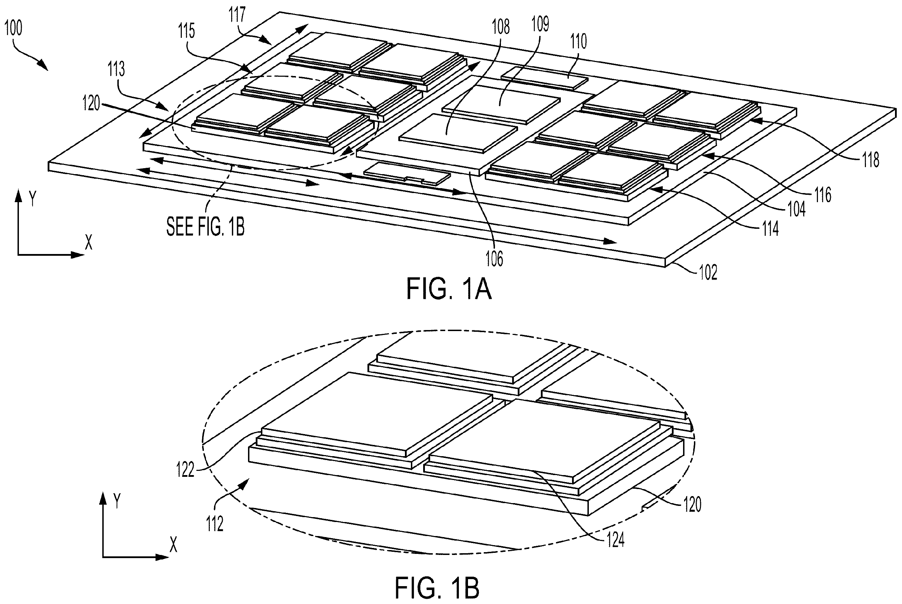

FIG. 1A depicts a perspective view of an exemplary embodiment of a device package architecture 100. FIG. 1B depicts an enlarged view of a portion of the device package architecture 100. A supporting substrate 102 supports an interposer 104. The interposer 104 connects one or more multi-device packages 112 on a multi-device die 120 to a first compute device 108 and a second compute device 109. The first compute device 108 and the second compute device 109 may be mounted on a base die 106. In some embodiments, a single compute device may be used, while in other embodiments, additional compute devices may be added, for example 4, 6, 8, 16 or 32 compute devices may be added. In some embodiments, the first compute device 108 and the second compute device 109 may share the same base die 106, while in other embodiments, each compute device may have a separate base die 106. In some embodiments, the base die 106 may be a silicon die, while in other embodiments a variety of semiconductor materials may be used. In some embodiments, the compute devices may include a die, a core, or chiplet, as well as any other suitable form of circuit. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit.

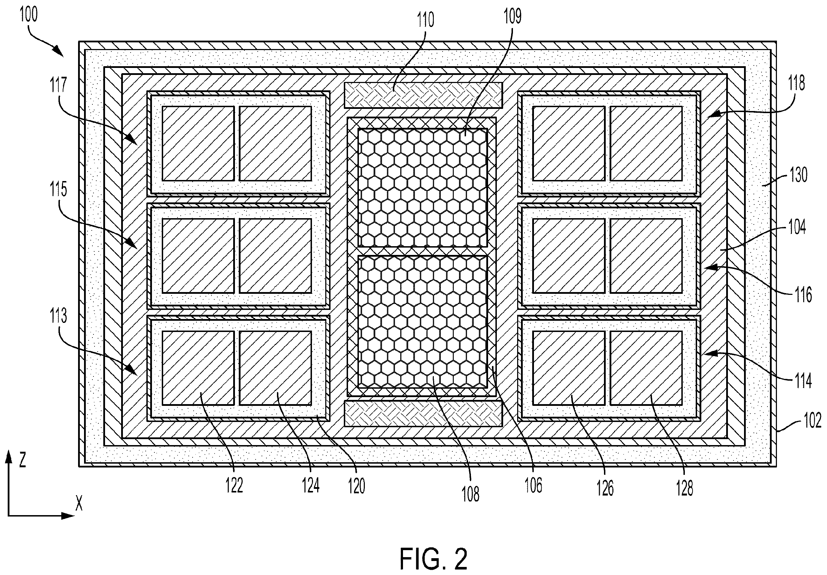

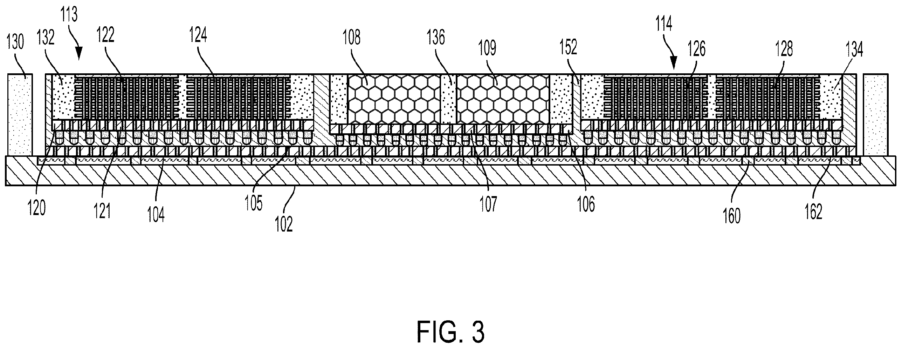

FIG. 2 provides a plan view of the device package architecture 100 showing the layout of the first compute device 108 and the second compute device 109 on the interposer 104. FIG. 3 provides a cross-sectional view of the device package architecture 100, showing the one or more multi-device packages 112 mounted on the base interposer 104. The one or more multi-device packages 112 may include or be a plurality of multi-device packages. In the example embodiment shown in FIGS. 1 and 2, included are a first multi-device package 113, a second multi-device package 114, a third multi-device package 115, a fourth multi-device package 116, a fifth multi-device package 117, and a sixth multi-device package 118. The first multi-device package 113, the third multi-device package 115 and the fifth multi-device package 117 are on a first side of the base die 106, while the second multi-device package 114, the fourth multi-device package 116 and the sixth multi-device package 118 are on a second side of the base die 106, opposite the first side.

The one or more multi-device packages 112 may include a multi-device die 120 on which are mounted multiple devices in the form of chips or dies. In the embodiment of FIGS. 1-3, the multi-device die 120 may have mounted on it a first device 122 and a second device 124. In some embodiments, the devices may be various forms of memory including DRAM, SRAM, and other forms of memory. In some embodiments, the devices may include a core device, for example a processor or other form of microcontroller to act as a controller. In some embodiments, the first device 122 and the second device 124 may each comprise a stack of one or more devices. In some embodiments, the stack of devices may include memory devices, core devices, and combinations thereof. The first device 122 and the second device 124 may, in some embodiments, include the same component devices, while in other embodiments the component devices in the first device 122 and the second device 124 may differ. In some embodiments, a through-via may electrically connect the individual devices within a device stack to each other and to the multi-device die 120.

The number of devices within each stack of devices may vary, and the number of devices and type of devices provided may vary based on the relative amount of computing desired for each device. For example, a desired ratio between core dies and memory dies may be desired, for example 1 core per 4 memory dies may be desired in some embodiments. However, in other embodiments, the ratio may vary, for example, and in some embodiments the ratio may be greater and include 1 core per 5, 6, 10, or even 16 memory die.

Additionally, as seen in the exemplary view of FIG. 3, a first encapsulation layer 132 may be provided between the first device 122, the second device 124 and multi-device die 120, such as a dielectric layer or an adhesive layer such as a resin or epoxy. In some embodiments, dielectric material such as silicon nitride (Si₃N₄), silicon dioxide (SiO₂), or any other suitable dielectric material, may be used to form the first encapsulation layer 132. In some embodiments, the first device 122 and the second device 124 may be encapsulated by the first encapsulation layer 132, and may include additional encapsulation layers on the sides or top of the first device 122 and the second device 124.

In some embodiments, one or more central encapsulation layers 136 may surround the compute devices including the first compute device 108 and the second compute device 109. In the example embodiment of FIG. 3, the central encapsulation layers 136 surround the first compute device 108 and the second compute device 109. Additionally, one or more overmolding layers 152 may surround the compute devices and the one or more multi-device packages 112. The overmolding layers 152 may be a dielectric material, and in some embodiments, the molding layer may provide mechanical support, such as holding the devices in places, as well as may provide electrical isolation, and may provide a thermal path for heat from the devices to transfer via.

On the one or more multi-device packages 112, the first device 122 and the second device 124 may be electrically coupled to one or more wiring layers 121 within the multi-device die 120. The one or more wiring layers 121 within the multi-device die 120 may in turn couple the first device 122 and the second device 124 to the interposer 104. The interposer 104 may include one or more redistribution layers 105 allowing the first device 122 and the second device 124 to electrically couple to the first compute device 108 and/or the second compute device 109 via the base die 106. The base die 106 may further include a base redistribution layer 107 allowing the first compute device 108 and the second compute device 109 to communicate with the supporting substrate 102.

While in the exemplary embodiments of FIG. 1A and 3, the first device 122 and the second device 124 are shown on a single one of the one or more multi-device packages 112, each of the one or more multi-device packages 112 may include a pair of devices on their respective multi-device die 120. Within the context of the exemplary embodiment shown in FIGS. 1-3, the first multi-device package 113 includes the first device 122 and the second device 124, while a third device 126 and a fourth device 128 are shown on the second multi-device package 114. The third device 126 and the fourth device 128 may include a second encapsulation layer 134, similar to the first encapsulation layer 132.

Although referred to as wiring layers, the one or more wiring layers 121 may take the form of series of pads, bumps, vias, through-vias, traces, redistribution layers and other forms of connection for redistributing signals in various combinations. Similarly, the one or more redistribution layers 105 and the base redistribution layer 107 may also take the form of series of pads, bumps, vias, through-vias, traces, redistribution layers and other forms of connection for redistributing signals in various combinations.

In some embodiments, the supporting substrate 102 may be an organic substrate such as a polymer, while in other embodiments an inorganic substrate such as a semiconductor including silicon may be used, or alternatively a SOI substrate such as glass. In some embodiments, the interposer 104 may be made of silicon, while in other embodiments another form of semiconductor such as germanium may be used. In some embodiments, multiple interposer substrates may be shared on a single supporting substrate. In some embodiments, the supporting substrate 102 may be multiple substrates, and in some embodiments may be multiple substrates stacked on top of each other. The supporting substrate 102 may have the interposer 104 mounted thereon in a variety of ways and may include pads, bumps, microbumps, pillars, balls, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The mounting method may further include a dielectric material, which may include a material such as an adhesive, resin, or elastomer which may form a connection in addition to a conductive connection. In some embodiments, the combination of a conductive connection and a dielectric connection may form a hybrid bond.

The interposer 104 may contain additional devices in addition to or in alternative to the compute devices and the multi-device packages. In the exemplary embodiment of FIG. 1A, one or more of a connectivity chiplet 110 may be mounted on the interposer 104. The connectivity chiplet 110 may contain I/O circuitry to allow the device package architecture 100 to connect to additional devices. For example, in some embodiments, the connectivity chiplet 110 may provide wireless connections, using one or more forms of a radiofrequency protocol for one or more frequency spectrums. In some embodiments, the connectivity chiplet 110 may provide for optical communication or wired communications, alone or in some combination with wireless communications.

Additionally, as shown in the exemplary embodiment of FIG. 2 and FIG. 3 a stiffener 130 may surround a perimeter on the supporting substrate 102. The stiffener 130 may be one or more sections of a stiff material to provide additional mechanical support to the supporting substrate 102. The stiffener 130 may be made of a material that has a higher elastic modulus than the elastic modulus of the supporting substrate 102, and thus may include materials such as a metal (e.g., aluminum, copper, or steel), a ceramic, a composite material, or another appropriate material. The stiffener 130 may be used in combination with a lid design to provide additional protection for the device package architecture 100, including protection from mechanical distortions, deformations, and warping. In some embodiments, a lid may be used to provide additional mechanical, thermal, and electrical protection for the device package architecture 100. In some embodiments, a lidless design may be used instead.

Also shown in FIG. 3 is a bonding layer 160. The bonding layer 160 may include conductive interconnections to couple the interposer 104 to the supporting substrate 102. Such conductive interconnections may include pads, bumps, microbumps, pillars, balls, and other forms such as controlled-collapse chip connection C4 bumps, alone or in combination. In some embodiments, the bonding layer 160 may also include a dielectric material or an adhesive to provide additional strength and connection between the interposer 104 and the supporting substrate 102. In some embodiments, the bonding layer 160 may provide a metallic bonding between the interposer 104 and the supporting substrate 102, a dielectric bonding between the interposer 104 and the supporting substrate 102, or in some embodiments a bonding between the interposer 104 and the supporting substrate 102. In some embodiments, a dielectric material or adhesive material may be inserted using an underfill technique and leave a residual 162 on the surface of the supporting substrate 102.

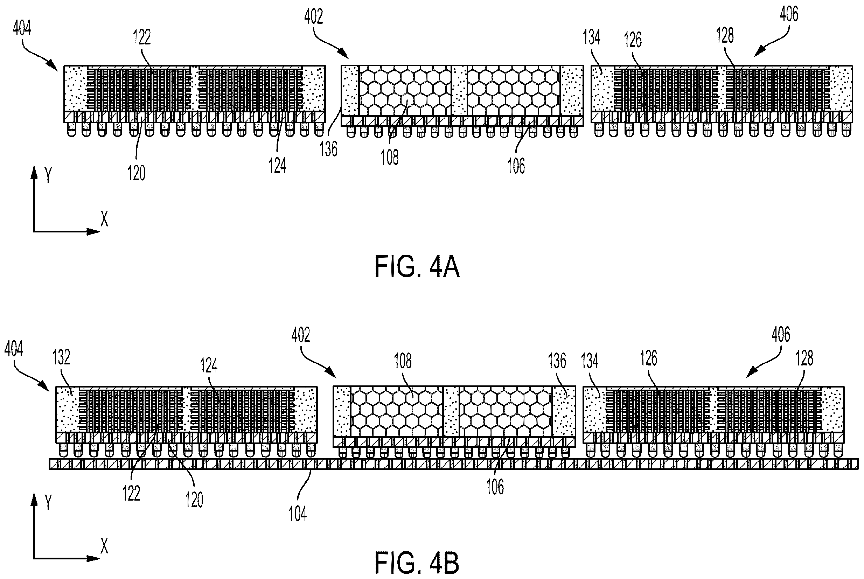

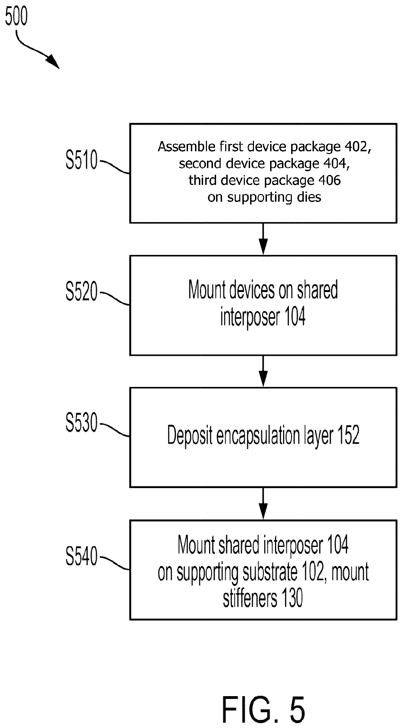

FIGS. 4A-4D depict an illustrative embodiment of a process of forming a device package architecture such as the device package architecture 100, or any other device package architectures shown herein. FIG. 5 depicts an example embodiment of a process 500 for forming a device package assembly corresponding to the illustrative embodiment of FIGS. 4A-4D.

FIG. 4A depicts at S510 in FIG. 5 where a first device package 402, a second device package 404, and a third device package 406 are each individually mounted on their own supporting die. For example, the first device package 402 may comprise the first compute device 108 and the second compute device 109 on the base die 106. The central encapsulation layer 136 may hold the first compute device 108 and the second compute device 109 on the base die 106, and may be shaped to form the first device package 402 into a substantially regular shape with planar surfaces. For the second device package 404 and the third device package 406, they may take the form of one or more multi-device packages 112 including the first device 122 and the second device 124 on the multi-device die 120. The first encapsulation layer 132 may hold the first device 122 and the second device 124 on the multi-device die 120, and may be shaped to form the second device package 404 and the third device package 406 into a substantially regular shape with planar surfaces. The mounting may take the form of a variety of bonding methods, including metal bonding, dielectric bonding, and hybrid bonding. In addition or in the alternative, additional interconnection techniques may be used, including adhesives such as resins or epoxies. The devices and compute devices may be mounted using back-end-of-line (BEOL) processes. In some embodiments, the first encapsulation layer 132, and the central encapsulation layer 136 may be provided prior to mounting the first device package 402, the second device package 404, and the third device package 406 on the interposer 104, while in some embodiments, the first encapsulation layer 132, and the central encapsulation layer 136 may be provided after mounting the first device package 402, the second device package 404, and the third device package 406 on the interposer 104.

FIG. 4B depicts at S520 in FIG. 5 where the first device package 402, the second device package 404 and the third device package 406 are mounted to the interposer 104 which is shared by all three devices. The mounting may take the form of a variety of bonding methods, including metal bonding, dielectric bonding, and hybrid bonding to connections on the devices, including pads, bumps, microbumps, pillars, balls, and other forms such as C4 bumps, alone or in combination. The mounting provides an electrical coupling between compute devices on the first device package 402 and the devices on the second device package 404 and the third device package 406.

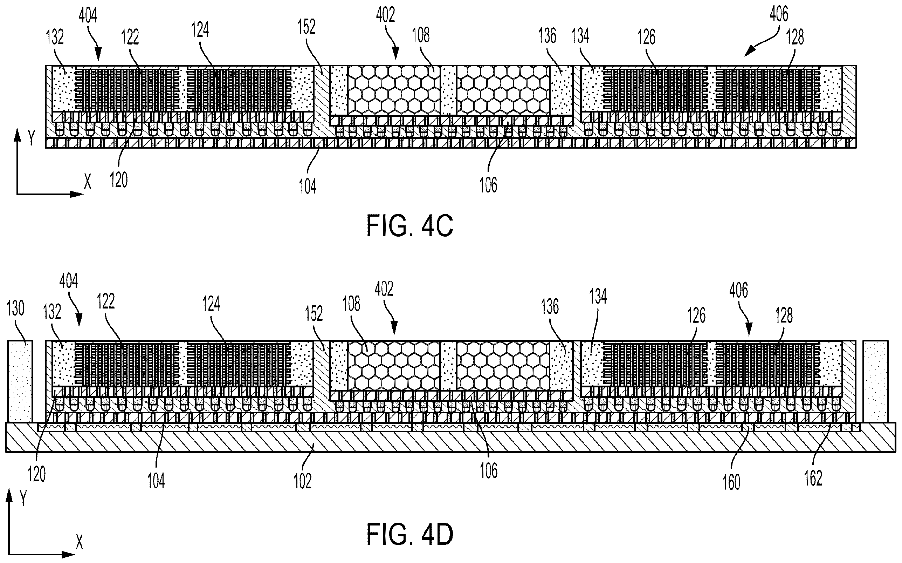

FIG. 4C depicts at S530 in FIG. 5 where after the first device package 402, the second device package 404 and the third device package 406 are mounted to the interposer 104, and the overmolding layers 152 are deposited over the first device package 402, the second device package 404 and the third device package 406. The overmolding layers 152 may be a dielectric material, and be deposited to encapsulate the first device package 402, the second device package 404 and the third device package 406 to the interposer 104, as well as to provide mechanical support, thermal insulation, and electrical separation. In some embodiments, the overmolding layers 152 may be one or more layers of a dielectric material, and may be an over molding process. In some embodiments, any excess material deposited on to the devices may be subject to a process to smooth and or planarize the surface of the devices, the process including one or more grinding, polishing, and smoothing processes, including chemical mechanical polishing (CMP). In some embodiments, a thermal processing step or heat treatment step may be used to secure the overmolding layers 152 in place.

FIG. 4D depicts at S540 in FIG. 5 where the interposer 104, on which the first device package 402, the second device package 404 and the third device package 406 are mounted, is mounted on the supporting substrate 102. The interposer 104 may be mounted to the supporting substrate 102 using a variety of bonding methods, including metal bonding, dielectric bonding, and hybrid bonding to connections on the devices, including pads, bumps, microbumps, pillars, balls, and other forms such as C4 bumps, alone or in combination. Additionally, the stiffener 130 may be formed on the supporting substrate 102 to surround the interposer 104. The stiffener 130 may be formed directly on the supporting substrate 102, such as by additive manufacturing of a suitable material to provide additional stiffness to the supporting substrate 102, or may be formed separately and mounted on the supporting substrate 102 using either a bonding process, or an adhesive such as an epoxy or resin. In some embodiments, an additional layer of molding material or encapsulation materials may be deposited between the interposer 104 and the stiffener 130. In some embodiments, a lid (not shown) may be further mounted on to the device package architecture 100 and be attached to the stiffener 130.

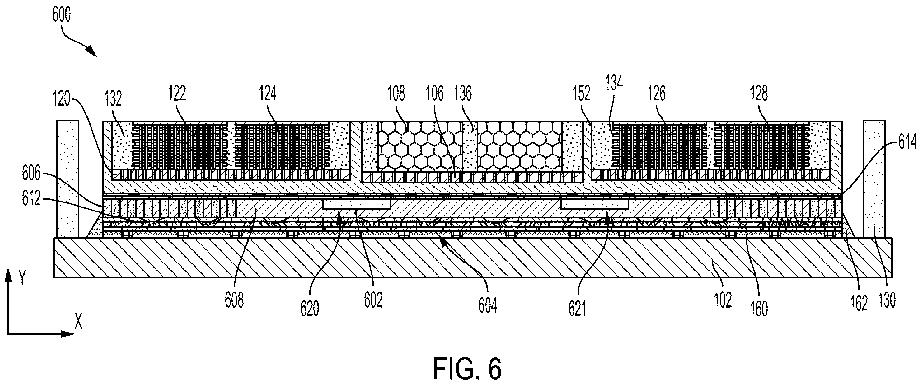

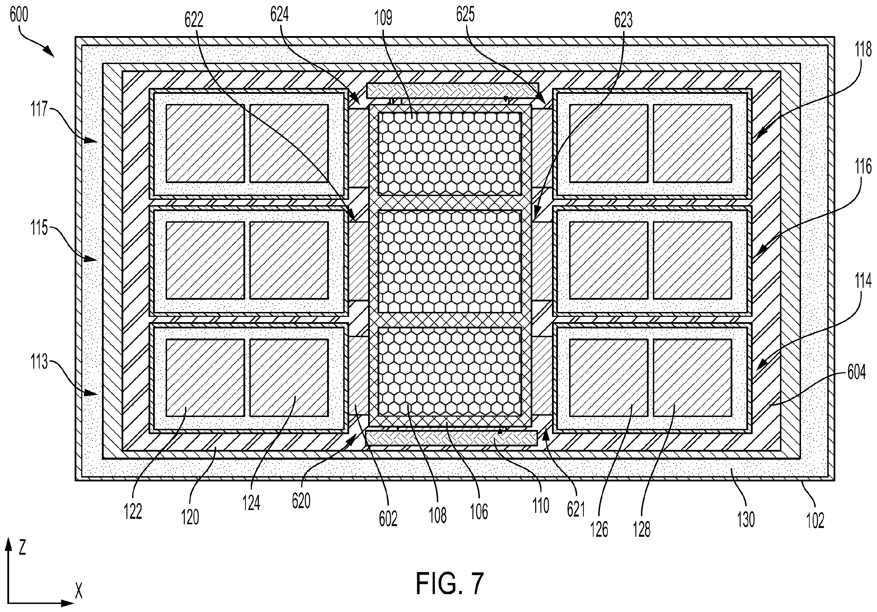

FIG. 6 depicts another exemplary embodiment of an embedded bridge device package architecture 600 in cross-sectional view. FIG. 7 provides a plan view of an exemplary embodiment of the embedded bridge device package architecture 600. The embedded bridge device package architecture 600 of FIG. 6 and FIG. 7 differs from the device package architecture 100 of FIGS. 1-3 by the presence of the bridge interposer 604, which differs from the interposer 104 in terms of the connections formed on and within the interposer structure. The bridge interposer 604 may include one or more embedded bridges 602 to provide a connection between the base die 106 and the one or more multi-device packages 112. The one or more embedded bridges 602 may include one or more conductive pathways to provide an electrical coupling between the base die 106 and the one or more multi-device packages 112. In some embodiments, the one or more embedded bridges 602 may be used to connect the base die 106 to a plurality of the one or more multi-device packages 112, while in other embodiments the one or more embedded bridges 602 may connect the base die 106 to only one of the multi-device packages 112. In some embodiments, as shown in FIG. 6 and FIG. 7, a plurality of the embedded bridges 602 may be used to connect each of the multi-device packages 112 to the base die 106, with one or more of the embedded bridge 602 for each of the multi-device packages 112.

The one or more embedded bridges 602 may include a first embedded bridge 620 to connect the base die 106 to the first multi-device package 113, a second embedded bridge 621 to connect the base die 106 to the second multi-device package 114, a third embedded bridge 622 to connect the base die 106 to the third multi-device package 115, a fourth embedded bridge 623 to connect the base die 106 to the fourth multi-device package 116, a fifth embedded bridge 624 to connect the base die 106 to the fifth multi-device package 117, and a sixth embedded bridge 625 to connect the base die 106 to the sixth multi-device package 118.

In addition, the bridge interposer 604 includes a first redistribution layer (RDL) 612 on the bottom side of the bridge interposer 604 and a second RDL 614 on the top side of the bridge interposer 604. Furthermore, conductive pillars 606 may electrically connect the first RDL 612 to the second RDL 614. The bridge interposer 604 may include a molding layer 608 between the first RDL 612 and the second RDL 614. In some embodiments, the molding layer 608 may be a dielectric material providing thermal insulation, mechanical separation, and electrical insulation between the first RDL 612, the second RDL 614 and conductive pillars 606. The first RDL 612 may provide a series of pads, bumps, vias, through-vias, traces, and other forms of connection for redistributing signals from the supporting substrate 102 to the bridge interposer 604. The second RDL 614 in turn may provide a series of pads, bumps, vias, through-vias, traces, and other forms of connection for redistributing signals from the bridge interposer 604 to the compute devices of the base die 106, and the one or more multi-device packages 112. The first RDL 612 and the second RDL 614 with the conductive pillars 606 thus may provide a connection between the supporting substrate 102, the compute devices of the base die 106, and the one or more multi-device packages 112.

Also depicted in the exemplary embodiment of FIG. 6 is the bonding layer 160. The bonding layer 160 may include conductive interconnections to couple the bridge interposer 604 to the supporting substrate 102. Such conductive interconnections may include pads, bumps, microbumps, pillars, balls, and other forms such as controlled-collapse chip connection C4 bumps, alone or in combination. In some embodiments, the bonding layer 160 may also include a dielectric material or an adhesive to provide additional strength and connection between the bridge interposer 604 and the supporting substrate 102. In some embodiments, the bonding layer 160 may provide a metallic bonding between the bridge interposer 604 and the supporting substrate 102, a dielectric bonding between the bridge interposer 604 and the supporting substrate 102, or in some embodiments a bonding between the bridge interposer 604 and the supporting substrate 102. In some embodiments, the bonding layer 160 may bond directly with the first RDL 612, while in other embodiments, intermediate layers may between the bonding layer 160 and the first RDL 612. In some embodiments, a dielectric material or adhesive material may be inserted using an underfill technique and leave a residual 162 on the surface of the supporting substrate 102.

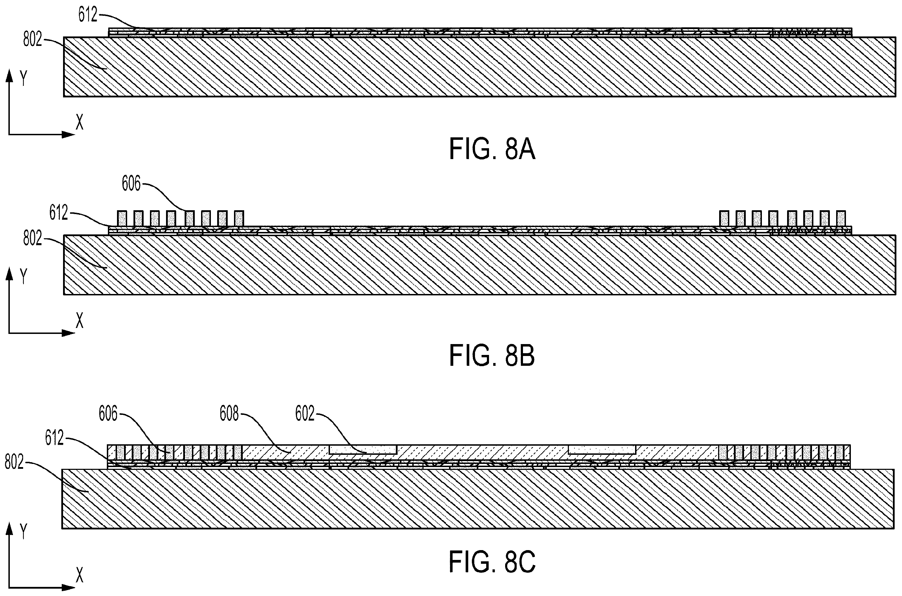

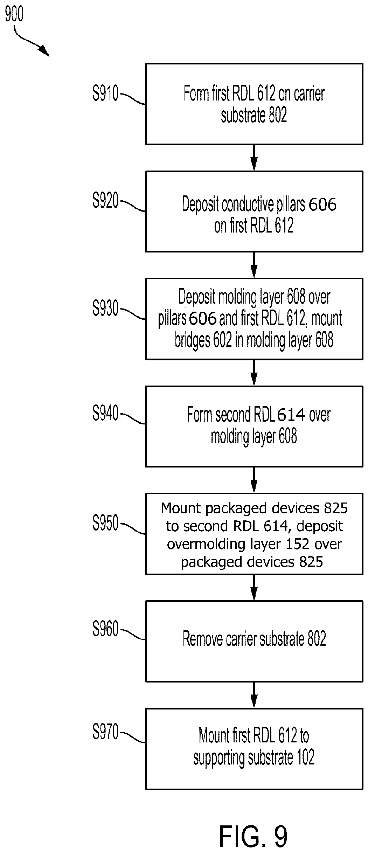

FIGS. 8A-8G depict an illustrative embodiment of a process of forming a device package architecture such as the embedded bridge device package architecture 600, or any other device package architectures shown herein. FIG. 9 depicts an example embodiment of a process 900 for forming a device package assembly corresponding to the illustrative embodiment of FIGS. 8A-8G.

FIG. 8A depicts at S910 in FIG. 9 where the first RDL 612 is formed on a carrier substrate 802. The carrier substrate 802 may be any suitable substrate, such as a glass substrate. In some embodiments, prior to the first RDL 612 being formed on the carrier substrate 802, a release layer may be formed on the carrier substrate 802. The release layer may comprise a material such as a polymer, wax, epoxy, or resin which acts as a sacrificial layer and may be cleanly removed from the carrier substrate 802 and the first RDL 612. In some embodiments, the first RDL 612 may be formed using complementary metal-oxide-semiconductor (CMOS) processes, such as depositing, lithography, etching, passivation directly on the carrier substrate 802. In some embodiments, the first RDL 612 may be formed on a separate substrate and transferred to the carrier substrate 802.

FIG. 8B depicts at S920 in FIG. 9 where conductive pillars 606 are formed on the first RDL 612. The conductive pillars 606 may comprise a conductive material, including metals such as copper, as well as other known conductive materials, such as doped carbon. The conductive pillars 606 are bonded to the first RDL 612 and may form an interconnection layer for the second RDL 614 added later. In some embodiments, the conductive pillars 606 may be bonded using metal diffusion bonding between a metallic material forming the conductive pillars 606 and corresponding metal materials within the first RDL 612.

FIG. 8C depicts at S930 in FIG. 9 where the molding layer 608 is deposited over the conductive pillars 606 and the first RDL 612. The molding layer 608 may be a dielectric material, and be deposited to provide electrical separation between the first RDL 612 and the second RDL 614 added in at S940. The molding layer 608 may also provide a dielectric surface for providing a hybrid bonding structure with the second RDL 614 with the base die 106 and the one or more multi-device packages 112. The molding layer 608 may also provide a surface for embedding one or more of the one or more embedded bridges 602. After embedding one or more of the one or more embedded bridges 602, the surface of the one or more of the one or more embedded bridges 602, the molding layer 608 and the conductive pillars 606 may be subject to a process to smooth and or planarize the surface, the process including one or more grinding, polishing, and smoothing processes, including CMP.

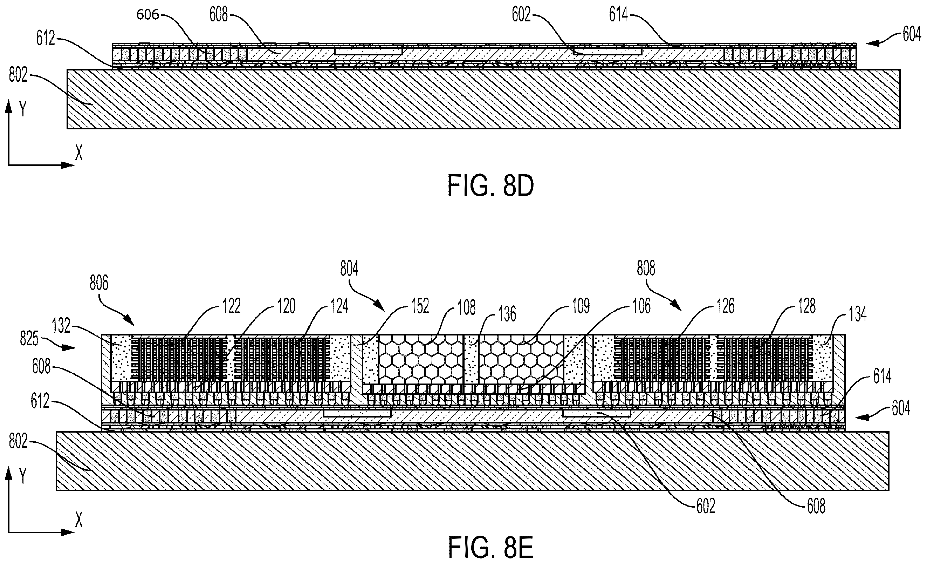

FIG. 8D depicts at S940 in FIG. 9 where the second RDL 614 is formed on the surface of the conductive pillars 606, the molding layer 608, and one or more of the one or more embedded bridges 602. The second RDL 614 includes a series of pads, bumps, vias, through-vias, traces, and other forms of connection for redistributing signals from the embedded layers to an appropriate location on the top of second RDL 614. In some embodiments, a portion of the molding layer 608 may be exposed to provide a suitable dielectric surface for forming hybrid bonds. The formation of the second RDL 614 with the first RDL 612, and the components between thus may be referred to as the bridge interposer 604.

FIG. 8E depicts at S950 in FIG. 9 where the packaged devices 825 are mounted on the bridge interposer 604. The packaged devices 825 include a first packaged device 804, a second packaged device 806, and a third packaged device 808 which may be individually assembled devices on their own supporting die. For example, a first packaged device 804 may comprise the first compute device 108 and the second compute device 109 on the base die 106, with a central encapsulation layer 136 encapsulating the first compute device 108 and the second compute device 109 on the base die 106. The second packaged device 806 and the third packaged device 808 may each take the form of one or more multi-device packages 112 including the first device 122 and the second device 124 on the multi-device die 120, with a first encapsulation layer 132 encapsulating the first device 122 and the second device 124 on the multi-device die 120. The mounting may be performed by a variety of bonding methods, including metal bonding, dielectric bonding, and hybrid bonding. In addition or in the alternative, additional interconnection techniques may be used, including adhesives such as resins or epoxies. The devices and compute devices may be mounted using BEOL processes. In some embodiments, the first encapsulation layer 132, and the central encapsulation layer 136 may be provided prior to mounting the packaged devices 825 on the bridge interposer 604, while in some embodiments, the first encapsulation layer 132, and the central encapsulation layer 136 may be provided after mounting the packaged devices 825 on the bridge interposer 604.

After the packaged devices 825 are mounted to the bridge interposer 604, and one or more overmolding layers 152 may be deposited over the first packaged device 804, the second packaged device 806 and the third packaged device 808. The overmolding layers 152 may be deposited to encapsulate the first packaged device 804, the second packaged device 806 and the third packaged device 808 on the bridge interposer 604, as well as to provide mechanical support, thermal insulation, and electrical separation. In some embodiments, the overmolding layers 152 may be one or more layers of a dielectric material, and may be an overmolding process. In some embodiments, any excess material deposited onto the devices may be subjected to a process to smooth and or planarize the surface of the devices, the process including one or more grinding, polishing, and smoothing processes, including CMP. In some embodiments, a thermal processing step or heat treatment step may be used to secure the overmolding layers 152 in place.

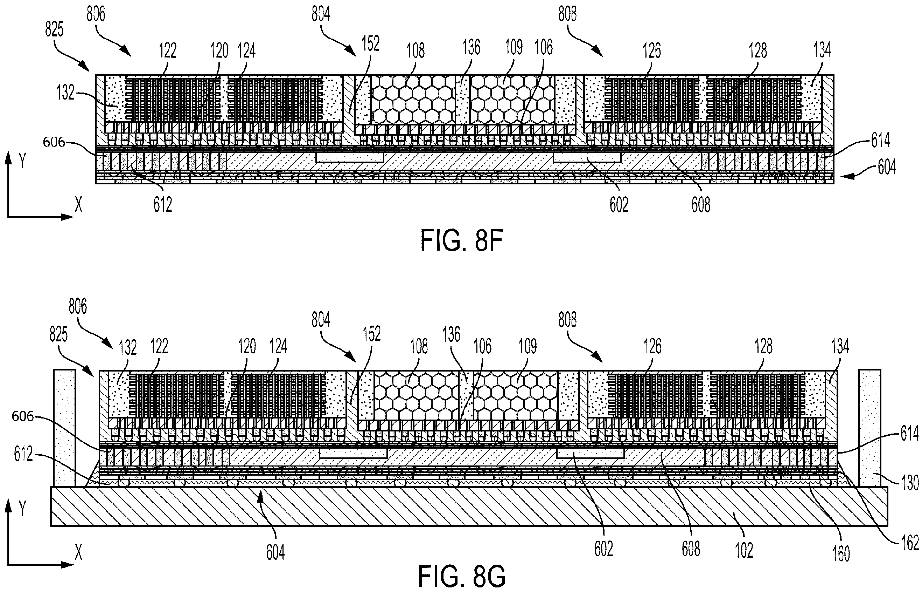

FIG. 8F depicts at S960 in FIG. 9 where the bridge interposer 604 with the packaged devices 825 mounted thereon is released from the carrier substrate 802 at the first RDL 612. The carrier substrate 802 may be released, for example, by using one or more of layer release, chemical release, thermal release, or photo release techniques to release an adhesive layer coupling the carrier substrate 802 to the first RDL 612. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

Additionally, at S960, interconnections may be prepared for mounting the bridge interposer 604 onto the supporting substrate 102. The interconnections may include pads, bumps, microbumps, pillars, balls, and other forms such as C4 bumps, alone or in combination. In some embodiments, a dielectric layer or adhesive layer, including underfill may also be included.

FIG. 8G depicts at S970 in FIG. 9 where the bridge interposer 604 with the packaged devices 825 mounted thereon is mounted on the supporting substrate 102 via the bonding layer 160. The bonding layer 160 may include conductive interconnections to couple the bridge interposer 604 to the supporting substrate 102 including pads, bumps, microbumps, pillars, balls, and other forms such as controlled-collapse chip connection C4 bumps, alone or in combination. In some embodiments, the bonding layer 160 may also include a dielectric material or an adhesive, like underfill material, to provide additional strength and connection between the bridge interposer 604 and the supporting substrate 102. In some embodiments, the bonding layer 160 may provide a metallic bonding between the bridge interposer 604 and the supporting substrate 102, a dielectric bonding between the bridge interposer 604 and the supporting substrate 102, or in some embodiments a hybrid bonding between the bridge interposer 604 and the supporting substrate 102. In some embodiments, the bonding layer 160 may be directly bonded to the first RDL 612, while in other embodiments, there may be intermediate layers between the bonding layer 160 and the first RDL 612. In some embodiments, a dielectric material or adhesive material may be inserted using an underfill technique and leave a residual 162 on the surface of the supporting substrate 102. In some embodiments, a heat treatment or other thermal process may be provided to strengthen the bond between the supporting substrate 102 and the bridge interposer 604.

Additionally, the stiffener 130 may be formed on the supporting substrate 102 to surround the bridge interposer 604. The stiffener 130 may be formed directly on the supporting substrate 102, such as by additive manufacturing of a suitable material to provide additional stiffness to the supporting substrate 102, or may be formed separately and mounted on the supporting substrate 102 using either a bonding process, or an adhesive such as an epoxy or resin. In some embodiments, an additional layer of molding material or encapsulation materials may be deposited between the bridge interposer 604 and the stiffener 130. In some embodiments, a lid may be further mounted on to the device package architecture 100 and be attached to the stiffener 130.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first layer including a first compute device (108), a first multi-device package (113; 404; 806), and a second multi-device package (114; 406; 808), wherein the first compute device (108) is arranged between the first multi-device package (113; 404; 806) and the second multi-device package (114; 406; 808); and
a second layer (104; 604) including a first redistribution layer (614) on a first side of the second layer (104; 604) facing the first layer, the first redistribution layer (614) is configured to electrically connect the first compute device (108) to the first multi-device package (113; 404; 806) and the first redistribution layer (614) is configured to electrically connect the first compute device (108) to the second multi-device package (114; 406; 808).

2. The device of claim 1, wherein the first layer includes a third multi-device package (115) and a fourth multi-device package (116), wherein the first compute device (108)is arranged between the third multi-device package (115) and the fourth multi-device package (116); and
the first redistribution layer (105) is configured to electrically connect the first compute device (108) to the third multi-device package (115) and the first redistribution layer (105) is configured to electrically connect the first compute device (108) to the fourth multi-device package (116).

3. The device of claim 2, wherein the first compute device is arranged between the second multi-device package and the fourth multi-device package.

4. The device of claim 1 or 2, wherein the first layer further includes a second compute device (109), a fifth multi-device package (117), and a sixth multi-device package (118), wherein the second compute device (109) is arranged between the sixth multi-device package (117) and the fifth multi-device package (118); and
the first redistribution layer (105) is configured to electrically connect the second compute device (109) to the fifth multi-device package (117) and the first redistribution layer (105) is configured to electrically connect the second compute device (109) to the sixth multi-device package (118).

5. The device of any one of claims 1 to 4, wherein the second layer (604) includes a second redistribution layer (612) on a second side of the second layer (604) opposite the first side of the second layer (604).

6. The device of claim 5, wherein a first bridge (602) is arranged between the first redistribution layer (614) and the second redistribution layer (612).

7. The device of any one of claims 1 to 6, wherein the first multi-device package (113; 404; 806) includes at least a first device stack (122) and a second device stack (124) on a first multi-device die (120),
wherein the first device stack (122) exemplarily includes at least one of a memory device and a processing device, and/or
wherein the first multi-device die (120) is exemplarily configured to electrically couple the first device stack (122) and the second device stack (124) to the first redistribution layer (105; 614).

8. A system comprising:
a first layer including a first compute device (108), a first multi-device package (113), and a second multi-device package (114), wherein the first compute device (108) is arranged between the first multi-device package (113) and the second multi-device package (114); and
a second layer (604) including a first bridge (620) and a second bridge (621), wherein the first bridge (620) electrically couples the first compute device (108) to the first multi-device package (113), and wherein the second bridge (621) electrically couples the first compute device (108) to the second multi-device package (114).

9. The system of claim 8, wherein the first layer includes a second compute device (109), a third multi-device package (115), and a fourth multi-device package (116); wherein the second compute device (109) is arranged between the fourth multi-device package (116) and the third multi-device package (115); and
wherein the second layer (604) further includes a third bridge (622) and a fourth bridge (623), and wherein the third bridge (622) is configured to electrically couple the second compute device (109) to the third multi-device package (115), and wherein the fourth bridge (623) is configured to electrically couple the second compute device (109) to the fourth multi-device package (116).

10. The system of claim 8 or 9, wherein the second layer (604) includes a first redistribution layer (614) on a first side of the second layer, wherein the first redistribution layer (614) is between the first bridge (602) and the first multi-device package (113).

11. The system of claim 10, wherein the second layer (604) includes a second redistribution layer (612), wherein the second redistribution layer (612) is on a second side of the second layer (604) opposite the first side, and wherein the first bridge (620) is between the first redistribution layer (614) and the second redistribution layer (612).

12. The system of any one of claims 8 to 11, wherein the first multi-device package (113) includes at least one of a memory device and a processing device.

13. The system of any one of claims 8 to 12, wherein the first layer includes a base die (106), and wherein the base die (106) is arranged between the first compute device (108) and the first bridge (620).

14. A method comprising:
forming an interposer (604) including a first bridge (620) and a second bridge (621), and forming a first redistribution layer (614) on a first side of the interposer (604), the first redistribution layer (614) communicatively coupled to the first bridge (620) and the second bridge (621);
mounting a compute device (108) on the interposer (604) and on the first redistribution layer (614);
mounting a first multi-device package (806) and a second multi-device package (808) on the interposer (604) and on the first redistribution layer (614), wherein the compute device (108) is arranged between the first multi-device package (806) and the second multi-device package (808);
depositing a dielectric layer over the interposer (604);
coupling the first multi-device package (806) to the compute device (108) via the first bridge (620); and
coupling the second multi-device package (808) to the compute device (108) via the second bridge (621).

15. The method of claim 14, wherein the first multi-device package (806) and the second multi-device package (808) have substantially the same devices,
wherein mounting the compute device (108) on the interposer (604) exemplarily includes mounting a base die (106) on the first redistribution layer (614), and mounting the compute device (108) on the base die (106), and/or
wherein forming the interposer (604) exemplarily further comprises forming a second redistribution layer (612) on a second side of the interposer (604), wherein the second side of the interposer (604) is opposite the first side of the interposer (604), and/or
wherein depositing the dielectric layer over the interposer (604) exemplarily includes depositing dielectric material between the first multi-device package (806), the second multi-device package (808) and the compute device (108).
